# EUROPEAN PATENT SPECIFICATION

(11) **EP 0 630 989 B1**
(45) Date of publication and mention of the grant of the patent: **12.01.2000**
(21) Application number: 94109547.3
(22) Date of filing: 21.06.1994
(51) Int. Cl.: C23C 16/44, C23C 16/50, C23C 16/02, B05D 3/06, B05D 3/04

(54) **Method of plasma chemical vapor deposition of layer with improved interface**
Verfahren zur plasmaunterstützten chemischen Abscheidung von Schichten aus der Dampfphase unter Verbesserung der Zwischenflächen
Procédé pour le plasma-dépôt chimique en phase vapeur de souches ayant une interface améliorée

(30) Priority: 21.06.1993 US 80019
(43) Date of publication of application: 28.12.1994
(73) Proprietor: APPLIED MATERIALS, INC., Santa Clara, California 95052-8039 (US)
(72) Inventor: Robertson, Robert, Palo Alto, California 94301 (US); Kollrack, Marc Michael, Alameda, California 94501 (US); Lee, Angela T., San Jose, California 95129 (US); Takehara, Takako, Hayward, California 94541 (US); Feng, Guofu Jeff, San Jose, California 95127 (US); Connolly, Robert, San Jose, California 95148 (US); Law, Kam, Union City, California 94587 (US); Maydan, Dan, Los Altos Hills, California 94022 (US)
(74) Representative: Kahler, Kurt, Dipl.-Ing.

(56) References cited:
- DE-C- 4 005 956
- GB-A- 2 155 862
- GB-A- 2 192 196
- GB-A- 2 245 600
- US-A- 4 436 761
- US-A- 5 135 775

## Description

### Field of the Invention

The present invention is directed to a method of improving the interface between layers formed by plasma chemical vapor deposition (CVD), and, more particularly, to a method of treating a device being coated to improve the interface between the device and a layer deposited thereon by plasma CVD.

### Background of the Invention

Plasma chemical vapor deposition (CVD) is a process used for the deposition of layers of various material on a body (substrate), particularly in the manufacture of semiconductor devices and the like formed on an insulating body, such as glass or a semiconductor body. In plasma CVD, a body is placed in a deposition chamber which includes a pair of spaced electrodes. The body is generally mounted on a susceptor which can also serve as one of the electrodes. A flow of a deposition gas is provided in the deposition chamber. A radio frequency (rf) voltage is applied between the electrodes which has a rf power sufficient to cause a plasma to be formed in the deposition gas. The plasma causes the deposition gas to decompose and deposit a layer of the desired material on the body. Additional layers can be deposited on the first layer by providing in the deposition chamber a flow of a deposition gas containing the materials of the additional layer to be deposited. Each deposition gas is subjected to a plasma which results in the deposition of the layer of the desired material.

One problem which has arisen in this process is a tendency toward a poor interface between a deposited layer and the body or between adjacent deposited layers. Such poor interface can result in poor adhesion between the deposited layer and either the body or the previous layer on which the layer is deposited. Consequently, poor device performance resulted. The poor interface is generally discernable by the deposited layer having a hazy appearance and/or having bubbles formed therein. It is believed that the poor interface is the result of contaminants on the surface being coated, such as particles or undesired gas species, or different film properties at the interface as compared to the bulk film properties. Therefore, it would be desirable to be able to improve the interface between the deposited layer and the body or layer on which it is deposited to improve the adhesion therebetween.

In GB-A-2 245 600 a process of metallizing a surface using a plasma is disclosed. In particular, the surface to be metallized is pretreated in the enclosure by a nitrogen post-discharge microwave plasma without an addition of carbonyl metal compound, in order to enhance the adhesion of the metal layer being subsequently deposited. The metallization step is then carried out in situ in the same enclosure by injection of carbonyl compound.

The present invention is directed to a method of improving the interface between a surface and a layer deposited thereon by plasma chemical vapor deposition according to claim 1.

Preferred embodiments of the method of Claim 1 are claimed in claims 2 to 8.

The present invention is directed to a method of depositing at least one layer on the surface of a substrate. The method comprises placing the substrate in a deposition chamber and on a susceptor spaced from an electrode. A flow of an inactive gas is provided in the chamber with the inactive gas being of a material which does not adversely affect the substrate deposit a layer thereon. Preferably, a voltage is applied between the electrode and susceptor at rf power sufficient to generate a plasma in the inactive gas. The surface of the body is subjected to the plasma of the inactive gas. A flow of deposition gas is then provided in the chamber and rf power is applied to the deposition gas to generate a plasma therein which reacts the deposition gas and deposits a layer on the substrate.

The invention will be better understood from the following more detailed description and claims taken with the accompany drawing.

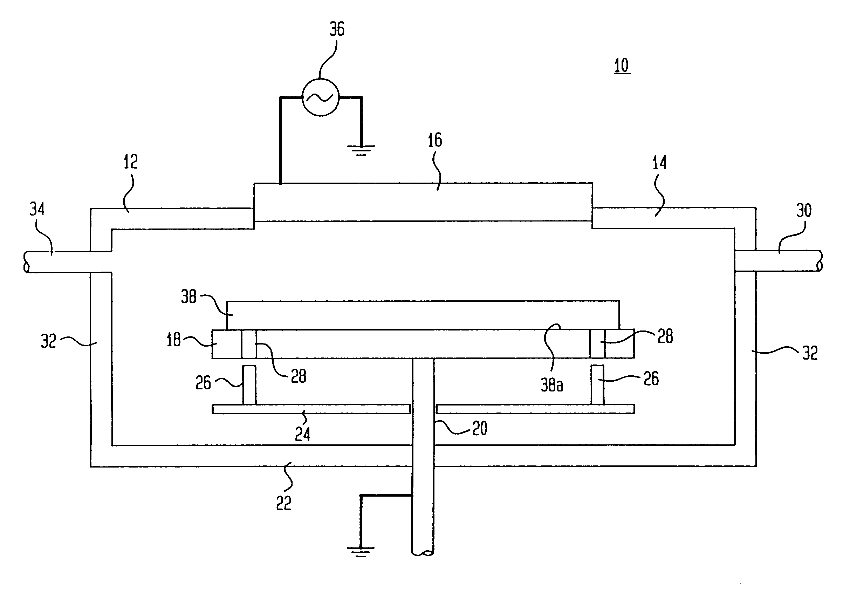

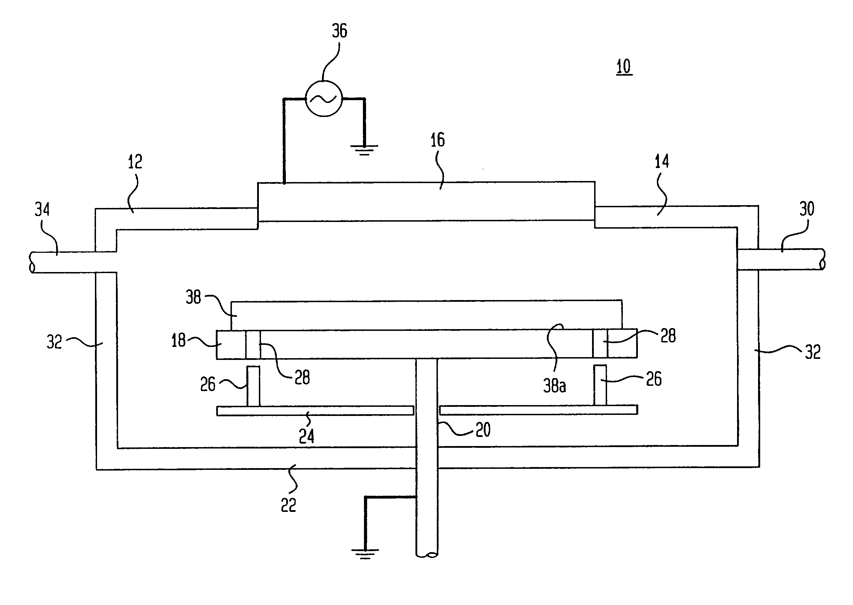

### Brief Description of the Drawing

The FIGURE of the drawing is a schematic sectional view of a plasma CVD apparatus in which the method in accordance with the present invention can be carried out.

It should be understood that the drawing is not necessarily to scale.

### Detailed Description

In a typical method of coating a body (substrate), such as of glass, silicon or other semiconductor material, with one or more layers by plasma CVD, the body is placed in a deposition chamber on a susceptor. A flow of a deposition gas or mixture of gases is admitted into the deposition chamber and a voltage is applied between an electrode and the susceptor, which are spaced apart. The voltage provides sufficient rf power applied to the deposition gas which, at the pressure of the deposition gas, generates a plasma in the gas. The plasma causes the gas to react and deposit the desired layer on a surface of the body. In a typical embodiment, a power of between about 0.15 and 0.8 watts/cm² is used to form the plasma in the deposition gas. The total power is determined by the area of the electrode to which the voltage is applied to form the plasma. After the desired layer or layers are deposited on the substrate body, the body is lifted off of the susceptor and removed from the deposition chamber.

In a method in accordance with the present invention, before a layer is deposited on the body using the method described hereinabove, a flow of an inactive gas is provided in the deposition chamber. For the purpose of this invention, an inactive gas is defined as one which does not adversely affect the body or any coatings thereon and which does not result in an additional coating(s) being applied to the body. Suitable gases typically include hydrogen (H₂), argon (Ar), nitrogen (N₂) and ammonia (NH₃). A power is applied to the inactive gas to cause a plasma to be formed. The power applied to the inactive gas is preferably less than that which is used to form the plasma in the deposition gas, i.e., less than 0.15 watts/cm² and preferably between 0.03 and 0.14 watts/cm². The amount of time that the coated body is subjected to the plasma of the inactive gas can be as little as about two seconds, but is preferably between 5 and 15 seconds. Longer times are allowable. Once the body is subjected to the plasma of the inactive gas, the layer is then deposited on the treated body in the manner described hereinabove. Preferably, the plasma of the inactive gas is maintained while the power is increased and the flow of the deposition gas is provided in the deposition chamber to convert the plasma to that of the deposition gas. Thus, the body is substantially continuously subjected to a plasma while switching from the inactive gas to the deposition gas.

It has been found that depositing the layer on the treated body provides an improved interface between the layer and the body so as to achieve improved adherence between the layer and the body. The improved interface is evidenced by less haze and fewer bubbles in the deposited layer. It is believed that the plasma of the inactive gas continuously followed by the plasma of the deposition gas prevents any contaminants from accumulating on the surface being coated to improve the interface between the layer and the surface. If an additional layer or layers are to be deposited on the first layer, the already deposited layer is subjected to the plasma of the inactive gas prior to depositing the additional layer. This provides an improved interface between the additional deposited layer and the previously deposited layer. As stated above, it is preferred to maintain a plasma in the deposition chamber while switching from one gas and power to another. The use of lower power to form the plasma in the inactive gas is preferable since it prevents damage to the surface being coated, particularly if the surface is of another layer.

Referring now to the FIGURE of the drawing, there is shown a schematic sectional view of a plasma CVD apparatus 10 in which the method in accordance with the present invention can be carried out. Apparatus 10 comprises a deposition chamber 12 having a top wall 14 with an opening therethrough and a first electrode 16 within the opening. Alternatively, the top wall 14 can be solid with the electrode 16 being adjacent either the inner or outer surface thereof. Within the chamber 12 is a susceptor 18 in the form of a plate which extends parallel to the first electrode 16. The susceptor 18 is typically of aluminum and is coated with a layer of aluminum oxide. The susceptor 18 is connected to ground so that it serves as a second electrode. The susceptor 18 is mounted on the end of a shaft 20 which extends vertically through a bottom wall 22 of the deposition chamber 12. The shaft 20 is movable vertically so as to permit the movement of the susceptor 18 vertically toward and away from the first electrode 16. A lift-off plate 24 extends horizontally between the susceptor 18 and the bottom wall 22 of the deposition chamber 12 substantially parallel to the susceptor 18. Lift-off pins 26 project vertically upwardly from the lift-off plate 24. The lift-off pins 26 are positioned to be able to extend through holes 28 in the susceptor 18, and are of a length slightly longer than the thickness of the susceptor 18. Although there are only two lift-off pins 26 shown, there may be more of the lift-off pins 26 spaced around the lift-off plate 24. An outlet pipe 30 extends through a side wall 32 of the deposition chamber 12 and is connected to means (not shown) for evacuating the deposition chamber 12. An inlet pipe 34 also extends through another portion of the outer wall 32 of the deposition chamber 12, and is connected through a gas switching network (not shown) to sources (not shown) of various gasses. The first electrode 16 is connected to an electrical power source 36. A transfer plate (not shown) is typically provided to carry bodies through a load-lock door (not shown) and into the deposition chamber 12 and onto the susceptor 18, and to remove the coated bodies from the deposition chamber 12.

In the operation of the deposition apparatus 10, a body 38 is fed into the deposition chamber 12 and is placed on the susceptor 18 by the transfer plate (not shown). The body 38 is of a size to extend over the holes 28 in the susceptor 18. The susceptor 18 is positioned above the lift-off pins 26 (as is shown) by moving shaft 20 upwards such that the lift-off pins 26 do not extend through the holes 28, and the susceptor 18 and body 38 are relatively close to the first electrode 16. The deposition chamber 12 is evacuated through the outlet pipe 30, and an inactive gas, such as hydrogen, nitrogen, argon or ammonia, is provided into the deposition chamber 12. The pressure in the deposition chamber is set at between 26.7 and 466.6 Pa (0.2 and 3.5 Torr). The electrical power source 36 is turned on to provide rf power between the first electrode 16 and the susceptor 18 and through the inactive gas. The power is preferably between 0.03 and 0.14 watts/cm², with the total power being based on the area of overlap between the electrode 16 and the susceptor 18, and is sufficient to generate a plasma in the inert gas. The body 38 is subjected to the plasma of the inactive gas for at least two seconds, and preferably about 10 seconds.

After the body 38 is subjected to the plasma of the inactive gas in the manner described above, the power between the electrode 16 and susceptor 18 is increased to a level of typically between 0.15 and 0.8 watts/cm². This maintains the plasma of the inactive gas. A deposition gas is then fed into the deposition chamber 12 through the inlet pipe 34 to replace the inactive gas. The pressure in the deposition chamber is maintained at about 200 Pa (1.5 Torr). The power between the electrode 16 and susceptor 18 is sufficient to now generate a plasma in the deposition gas. The plasma causes the deposition gas to decompose and deposit a layer of a desired material on the surface of the body 38. Thus, the body 38 is continuously subjected to a plasma while the gas is switched from the inactive gas to the deposition gas.

The composition of the deposition gas depends on the material to be deposited. For example, to deposit silicon nitride (Si₃N₄), a deposition gas comprising a mixture of silane (SiH₄), ammonia (NH₃), and nitrogen (N₂) is used. To deposit a layer of amorphous silicon, a deposition gas comprising a mixture of silane (SiH₄) and hydrogen (H₂) is used. To deposit silicon oxide (SiO₂), a deposition gas comprising a mixture of silane (SiH₄) and nitrous oxide (N₂O) can be used. One of the gases used in the deposition gas mixture is often an inactive gas which is also used in the initial treatment of the body 38. If this is so, it is only necessary after the initial treatment to add to the flow of the inactive gas the other gas(es) which form the deposition gas mixture to achieve the deposition of the desired layer.

If more than one layer is to be deposited on the body 38, after the first layer is deposited, the first layer is then subjected to a plasma of an inactive gas. This is done in the same manner as described above for treating the body 38 prior to depositing the first layer. The second layer is then deposited on the first layer in the same manner as described above with regard to the first layer. Any number of layers can be deposited on the body 38 in succession. However, before depositing each layer, the previous layer is subjected a plasma of an inactive gas. It is preferred to maintain the plasma in the deposition chamber when switching from one gas to another, i.e., inactive gas to deposition gas or deposition gas to inactive gas. The treatment of the body 38 and each layer improves the interface between a deposited layer and either the body surface or a previously deposited layer so as to improve the adhesion therebetween. This improvement is indicated by a layer having an appearance which is less hazy and/or has less bubbles therein.

After the final layer is deposited on the body 38, the shaft 20 is moved downwardly to move the susceptor 18 and coated body 38 away from the first electrode 16 and toward the lift-off plate 24. As the susceptor 18 reaches the lift-off plate 24, the lift-off pins 26 extend through the holes 28 until they engage a bottom surface 38a of the body 38. Since the lift-off fins 26 are longer than the thickness of the susceptor 18, the lift-off pins 26 stop the downward movement of the body 38. Further downward movement of the susceptor 18 causes the separation of the body 38 from the susceptor 18. The coated body 38 is then picked up by the transfer plate (not shown) and removed from the deposition chamber 12.

In one typical embodiment of the apparatus 10 shown in the FIGURE of the drawings the electrode 16 and susceptor 18 are each 38 x 48 cm. A glass plate, which is the body 38, was transferred into a deposition chamber 12 and placed on the susceptor 18. The susceptor 18 was moved upwardly until there was a spacing of 962 mils (24 mm) between the susceptor 18 and an electrode 16. A flow of hydrogen gas was provided into the deposition chamber and a pressure of 106.7 Pa (0.8 Torr) was achieved. The power source 36 to the electrode 16 was turned on and rf power of 300 watts was provided. This created a plasma in the hydrogen gas. The glass plate was subjected to the hydrogen plasma for 10 seconds. The power to the electrode 16 was increased to 1200 watts which maintained the plasma of hydrogen. The flow of hydrogen gas was then replaced with a flow of a deposition gas comprising a mixture of silane, ammonia and nitrogen and a pressure of 200 Pa (1.5 Torr) was was achieved. The susceptor 18 was maintained at a spacing of 962 mils (24 mm) from the electrode 16. The power to the electrode 16 was sufficient to result in a plasma being achieved in the deposition gas mixture. The plasma caused the silane and ammonia to react and deposit a layer is silicon nitride on the surface of the glass plate. After a layer of silicon nitride of the desired thickness was achieved, the flow of the deposition gas was stopped, the power turned off and the coated glass plate was removed from the deposition chamber 12.

In another typical embodiment of the apparatus 10 shown in the FIGURE of the drawing the electrode 16 and susceptor 18 are each also 38 x 48 cm. A glass plate (which is the body 30) was transferred into the deposition chamber 12 and placed on a susceptor 18. The susceptor was moved upwardly toward an electrode 16 until there was a spacing of 962 mils (24 mm) therebetween. A flow of hydrogen was provided into the deposition chamber and a pressure of 106.7 Pa (0.8 Torr) was achieved. The power source 36 was turned on to obtain a power of 250 watts between the electrode 16 and susceptor 18. This resulted in the formation of a plasma in the hydrogen. The glass plate was subjected to the plasma of hydrogen for 10 seconds.

The power to the electrode 16 was increased to 1200 watts which maintained the plasma of hydrogen. The flow of hydrogen was then replaced with the flow of a deposition gas comprising a mixture of silane, ammonia and nitrogen. The pressure of the deposition gas was set at 200 Pa (1.5 Torr) and the spacing between the electrode 16 and susceptor 18 was maintained at 962 mils (24 mm). The power to the electrode 16 was sufficient to result in the formation of a plasma in the deposition gas which caused the deposition gas to react and deposit a layer of silicon nitride on the surface of the glass plate.

The power to the electrode 16 was decreased to 250 watts which was still sufficient to maintain a plasma of the deposition gas. The flow of the deposition gas was replaced with a flow of hydrogen which was maintained at a pressure of 106.7 Pa (0.8 Torr). The spacing between the electrode 16 and susceptor 18 was maintained at 962 mils (24 mm). The power to the electrode 16 was sufficient to generate a plasma in the hydrogen. The glass plate with the coating of silicon nitride thereon was subjected to the hydrogen plasma for 10 seconds.

The power to the electrode 16 was then increased to 250-300 watts which maintained the plasma of the hydrogen. The flow of only hydrogen was replaced with a flow of a second deposition gas comprising a mixture of silane and hydrogen which was set at a pressure of 106.7 Pa (0.8 Torr). The spacing between the electrode 16 and susceptor 18 was maintained at 962 mils (24 mm). The power to the electrode 16 was sufficient to generate a plasma in the second deposition gas. The plasma caused the silane to react to deposit a layer of amorphous silicon on the silicon nitride layer. The flow of the second deposition gas was stopped, the power source turned off, and the coated glass plate was removed from the deposition chamber 12.

Thus, there is provided by the present invention a method of treating a surface on which a layer is to be deposited by plasma CVD so as to improve the interface between the surface and the layer. The surface can be that of a body with the layer being deposited directly on a surface thereof, or can be that of a first layer on a body with a second layer being deposited on the first layer. The improved interface is achieved by treating the body in a plasma of an inactive gas which does not adversely affect the body and which does not in itself deposit a layer on the body. The improved interface is visually indicated by reduced haze and/or bubbles being formed on the layer which is deposited on the body.

It is to be appreciated and understood that the specific embodiments of the invention are merely illustrative of the general principles of the invention. Various modifications may be made consistent with the principles set forth. For example, inactive gases other than those listed above may be used as long as they can form a plasma and do not adversely affect the body or layer on which the layer is to be deposited, and do not in themselves deposit a layer on the body. Also, substrate bodies of material other than those listed above can be used.

## Claims

1. A method of growing a structure by plasma vapor deposition, comprising the steps of:
placing a substrate onto a processing position in a plasma reaction chamber (12);
a first step of flowing a first gas into said chamber (12) and exciting it into a plasma to deposit a layer of silicon nitride onto said substrate placed at said processing position;
a second step of flowing an inert gas into said chamber (12) and exciting it into a plasma to treat a surface of said layer of silicon nitride while said substrate is placed at said processing position;
a third step of flowing a third gas into said chamber and exciting it into a plasma to deposit a layer of amorphous silicon onto said layer of silicon nitride while said substrate placed at said processing position;
whereby the inert plasma treatment of the second step improves the interface between the silicon nitride layer and the silicon layer.

2. The method of claim 1, wherein
said first step includes applying a first level of RF power to said chamber;
said second step includes applying a second level of RF power to said chamber;
said third step includes applying a third level of RF power to said chamber; and
said second level is less than said first and third levels.

3. The method of claim 1 or 2,
wherein said inert, second gas consists essentially of a gas selected from the group of hydrogen, nitrogen, argon and ammonia.

4. The method of claim 3,
wherein said inert, second gas consists of hydrogen.

5. The method of claim 1 to 4,
wherein said first gas comprises silane, ammonia and nitrogen and said second gas comprises silane and hydrogen.

6. The method of claim 1 to 5, wherein said first, second, and third steps continuously maintain a plasma in said chamber (12).

7. The method of claim 1 to 6, further comprising a step performed before said first step of flowing a inert, fourth gas into said chamber (12) and exciting it into a plasma to treat a surface of said substrate.

## Patentansprüche

1. Verfahren zum Züchten einer Struktur durch Plasma-Dampfphasenabscheidung, welches die Schritte umfaßt:
Anordnen eines Substrats in einer Bearbeitungsposition in einer Plasmareaktionskammer (12);
einen ersten Schritt des Einleitens eines ersten Gases in die Kammer (12) und des Anregens desselben in ein Plasma, um eine Schicht aus Siliziumnitrid auf dem in der Bearbeitungsposition angeordneten Substrat abzuscheiden;
einen zweiten Schritt des Einleitens eines Inertgases in die Kammer (12) und des Anregens desselben in ein Plasma, um eine Oberfläche der Schicht aus Siliziumnitrid zu behandeln, während das Substrat in der Bearbeitungsposition angeordnet ist;
einen dritten Schritt des Einleitens eines dritten Gases in die Kammer und des Anregens desselben in ein Plasma, um eine Schicht aus amorphem Silizium auf der Schicht aus Siliziumnitrid abzuscheiden, während das Substrat in der Bearbeitungsposition angeordnet ist;
wobei die Inertplasma-Behandlung des zweiten Schritts die Grenzfläche zwischen der Siliziumnitridschicht und der Siliziumschicht verbessert.

2. Verfahren nach Anspruch 1, wobei
der erste Schritt das Anlegen eines ersten Pegels einer RF-Leistung an die Kammer umfaßt;
der zweite Schritt das Anlegen eines zweiten Pegels einer RF-Leistung an die Kammer umfaßt;
der dritte Schritt das Anlegen eines dritten Pegels einer RF-Leistung and die Kammer umfaßt; und
der zweite Pegel geringer ist als der erste und der dritte Pegel.

3. Verfahren nach Anspruch 1 oder 2,
wobei das inerte, zweite Gas im wesentlichen aus einem Gas besteht, das aus der Gruppe von Wasserstoff, Stickstoff, Argon und Ammoniak ausgewählt ist.

4. Verfahren nach Anspruch 3,
wobei das inerte, zweite Gas aus Wasserstoff besteht.

5. Verfahren nach Anspruch 1 bis 4,
wobei das erste Gas Silan, Ammoniak und Stickstoff umfaßt und das zweite Gas Silan und Wasserstoff umfaßt.

6. Verfahren nach Anspruch 1 bis 5, wobei der erste, der zweite und der dritte Schritt in der Kammer (12) ununterbrochen ein Plasma aufrechterhalten.

7. Verfahren nach Anspruch 1 bis 6, welches ferner einen vor dem ersten Schritt durchgeführten Schritt des Einleitens eines inerten, vierten Gases in die Kammer (12) und des Anregens desselben in ein Plasma, um eine Oberfläche des Substrats zu behandeln, umfaßt.

## Revendications

1. Procédé de croissance d'une structure au moyen d'un dépôt en phase vapeur activé par plasma, comprenant les étapes constituées de :
un positionnement d'un substrat sur un emplacement de traitement dans une chambre réactionnelle (12) à plasma,
une première étape consistant à faire s'écouler un premier gaz jusque dans ladite chambre (12) et à l'exciter en un plasma afin de déposer une couche de nitrure de silicium sur ledit substrat placé audit emplacement de traitement,
une seconde étape consistant à faire circuler un gaz inerte jusque dans ladite chambre (12) et à l'exciter en un plasma afin de traiter une surface de ladite couche de nitrure de silicium pendant que ledit substrat est placé audit emplacement de traitement,
une troisième étape consistant à faire circuler un troisième gaz jusque dans ladite chambre et à l'exciter en un plasma afin de déposer une couche de silicium amorphe sur ladite couche de nitrure de silicium pendant que ledit substrat est placé audit emplacement de traitement,
grâce à quoi le traitement par plasma inerte de la seconde étape améliore l'interface entre la couche de nitrure de silicium et la couche de silicium.

2. Procédé selon la revendication 1, dans lequel
ladite première étape comprend l'application d'un premier niveau de puissance HF à ladite chambre,
ladite seconde étape comprend l'application d'un second niveau de puissance HF à ladite chambre,
ladite troisième étape comprend l'application d'un troisième niveau de puissance HF à ladite chambre, et
ledit second niveau est inférieur auxdits premier et troisième niveaux.

3. Procédé selon la revendication 1 ou 2,
dans lequel ledit second gaz inerte est constitué essentiellement d'un gaz choisi parmi le groupe constitué de l'hydrogène, de l'azote, de l'argon et de l'ammoniac.

4. Procédé selon la revendication 3,
dans lequel ledit second gaz inerte est constitué d'hydrogène.

5. Procédé selon les revendications 1 à 4,
dans lequel ledit premier gaz comprend du silane, de l'ammoniac et de l'azote et ledit second gaz comprend du silane et de l'hydrogène.

6. Procédé selon les revendications 1 à 5, dans lequel lesdites première, seconde et troisième étapes entretiennent sans interruption un plasma dans ladite chambre (12).

7. Procédé selon les revendications 1 à 6, comprenant en outre une étape réalisée avant ladite première étape, constituant à faire s'écouler un quatrième gaz inerte jusque dans ladite chambre (12) et à l'exciter en un plasma afin de traiter une surface dudit substrat.
